# EUROPÄISCHE PATENTSCHRIFT

(11) **EP 1 316 809 B1**
(45) Veröffentlichungstag und Bekanntmachung des Hinweises auf die Patenterteilung: **24.04.2013**
(21) Anmeldenummer: 02025160.9
(22) Anmeldetag: 11.11.2002
(51) Int. Cl.: G01R 33/02, G01R 33/06

(54) **Vorrichtung zur Sensierung eines Magnetfeldes**
Device for sensing a magnetic field
Dispositif de détection d'un champ magnétique

(30) Priorität: 30.11.2001 DE 10159004
(43) Veröffentlichungstag der Anmeldung: 04.06.2003
(73) Patentinhaber: ROBERT BOSCH GMBH, 70442 Stuttgart (DE)
(72) Erfinder: Hauenstein, Henning M., 72762 Reutlingen (DE); Ernst, Stephan, 73760 Ostfildern (DE); Feiler, Wolfgang, 72766 Reutlingen (DE)

(56) Entgegenhaltungen:
- EP-A- 0 111 698
- R.S. POPOVIC ET.AL.: "Integrated Hall Sensor/Flux Concentrator Microsystems" INFORMACIJE MIDEM 31 (2001) 4, 10. - 12. Oktober 2001, Seiten 215-219, XP002253614
- MASI J.V.: "Electrically active polymers: an overview", PROCEEDINGS: ELECTRICAL INSULATION CONFERENCE AND ELECTRICAL MANUFACTURING AND COIL WINDING CONFERENCE, October 2001 (2001-10), pages 29-33, CINCINNATI, USA
- DRLJACA P.M.ET AL: 'High sensitivity Hall magnetic sensors using planar micro and macro flux concentrators' PROCEEDINGS OF 11TH INTERNATIONAL CONFERENCE ON SOLID STATE SENSORS AND ACTUATORS TRANSDUCERS '01/EUROSENSORS XV Juni 2001, MUNICH, GERMANY, Seiten 160 - 163

## Beschreibung

### Stand der Technik

Insbesondere im Automobilbereich wächst die Zahl potentieller Einsatzbereiche für Magnetfeldsensoren, z.B. für Drehmoment- oder Drehwinkelsensierung, oder zur berührungslosen, verlustarmen und potentialgetrennten Messung von Strömen

Es ist allgemein bekannt, magnetische Felder, beispielsweise von Stromleitern, durch Magnetfeldsensoren, wie z.B. Hallsensoren, bipolare Magnetotransistoren, magnetoresistive Widerstände, laterale Mag-FET-Strukturen und dergleichen, zu messen. Damit diese Bauelemente auch noch sehr kleine Magnetfelder messen können, ist es allgemein bekannt, diese Felder durch sogenannte Flußkonzentratoren zu verstärken, was durch geeignete Formgebung der jeweiligen Stromleiter oder durch Magnetkreise aus hochpermeablen Materialien erreicht wird. Solche Magnetkreise funktionieren ähnlich wie Transformatorenkerne, weisen aber den Nachteil auf, dass es oftmals nicht möglich ist, eine ideale Ankopplung des Sensors an den Magnetkreis zu erreichen, da infolge der Chipverpackung zusätzliche Luftspalte zwischen dem Magnetkreis und dem Sensor entstehen, wobei diese Luftspalte zusätzlich noch aufgrund thermischer oder mechanischer Schwankungen variieren können.

Aus der Druckschrift "Integrated Hell Sensor/Flux Concentrator Microsystems" von R.S. Popović et al. Midem 2001 Conference, S.215 bis 219 ist eine Vorrichtung zur Sensierung eines Magnetfeldes mit einem Substrat bekannt, bei dem ein auf dem Substrat angeordneter Magnetfeldsensor, beispielsweise ein Hallelement oder mehrere Hallelemente, vorhanden sind. Dabei ist die Vorrichtung zumindest teilweise von einer Verpackungssubstanz umgeben. Im Bereich des Magnetfeldsensors ist eine, die magnetische Flussdichte eines Magnetfeldes beeinflussende Substanz vorgesehen, die eine, die magnetische Flussdichte fokussierende oder defokussierende Wirkung am Magnetfeldsensor ergibt.

### Vorteile der Erfindung

Aus Kosten- und Bauraumgründen ist es jedoch vorteilhaft, wenn man die oben genannten flußkonzentrierenden Hilfsmittel möglichst klein und in einer für den Sensor optimalen Lage vorsieht. Hierzu ist die erfindungsgemäße Vorrichtung zur Sensierung eines Magnetfeldes gemäß dem Hauptanspruch vorgesehen, welche den Vorteil aufweist, die Empfindlichkeit bekannter Magnetfeldsensoren durch eine spezielle flußkonzentrierende Vergussmasse bzw. durch eine spezielle, die magnetische Flußdichte eines Magnetfeldes beeinflussende Substanz direkt auf dem Halbleiterchip zu erhöhen. Hierbei ist es erfindungsgemäß insbesondere vorteilhaft möglich, eine Empfindlichkeitssteigerung von Halbleiterbauelementen zu erreichen, die auf senkrecht zur Chipfläche, d. h. zur Substratebene, verlaufende Magnetfelder reagieren. Üblicherweise sind die genannten Sensoren auf die magnetische Flußdichte B sensitiv. Daher ist es erfindungsgemäß vorteilhaft möglich, durch geschicktes Design einer flusskonzentrierenden Vergussmasse, die direkt auf dem sensitiven Teil des Halbleiterchips bzw. des Magnetfeldsensors der erfindungsgemäßen Vorrichtung aufgebracht wird, eine effiziente Verstärkung des zu messenden magnetischen Flusses zu erreichen.

In vorteilhafter Weise ist es erfindungsgemäß weiterhin möglich, dass durch den On-Chip-Flußkonzentrator, d. h. die die magnetische Flußdichte beeinflussende Substanz, ein Großteil des Justageaufwandes, der nötig wäre, wenn der Sensor relativ zu einem externen Flußkonzentrator montiert werden müsste, entfallen kann. Weiterhin ist es erfindungsgemäß möglich, wesentlich kleinere und feiner strukturierte Flußkonzentratoren zu verwenden, wodurch Nebenschlüsse im Magnetkreis minimiert werden.

Weiterhin ist es erfindungsgemäß möglich, den Herstellungsprozess der Substanz relativ kostengünstig im Back-end der Sensorfertigung auch auf Waver-Level durchzuführen.

Durch die in den Unteransprüchen aufgeführten Maßnahmen sind vorteilhafte Weiterbildungen und Verbesserungen der im Hauptanspruch angegebenen Vorrichtung möglich.

Besonders vorteilhaft ist es, dass der Magnetfeldsensor auf oder in dem Substrat monolithisch integriert vorgesehen ist. Dadurch kann die Sensorherstellung zusammen mit der Substratprozessierung bewerkstelligt werden.

Weiterhin ist es vorteilhaft, dass auf oder in dem Substrat ein Auswerte- und/oder Ansteuerschaltkreis monolithisch integriert ist. Dadurch ist es möglich, besonders kostengünstig die Sensierung und die Auswertung der Sensorsignale bzw. die Ansteuerung des Sensors durchzuführen.

Weiterhin ist es von Vorteil, dass die die magnetische Flußdichte beeinflussende Substanz trichterförmig oder linsenförmig vorgesehen ist. Dadurch kann eine zusätzliche geeignete Flußlinienführung erreicht werden.

### Zeichnung

Ausführungsbeispiele der Erfindung sind in der Zeichnung dargestellt und in der nachfolgenden Beschreibung näher erläutert. Es zeigen
Figur 1 eine beispielhafte Vorrichtung zur Sensierung eines Magnetfeldes mit einem Magnetfeldsensor, eine die magnetische Flußdichte eines Magnetfeldes beeinflussende Substanz und eine Verpackungssubstanz,
Figur 2 ein weiteres Beispiel der Vorrichtung zur Sensierung eines Magnetfeldes mit einer trichterförmigen Ausgestaltung der die magnetische Flußdichte beeinflussenden Substanz,
Figur 3 ein Ausführungsbeispiel der erfindungsgemäßen Vorrichtung mit ebenfalls einer trichterförmig vorgesehenen, die magnetische Flußdichte beeinflussenden Substanz, wobei jedoch eine weitere die magnetische Flußdichte beeinflussende Substanz mit abschirmender Wirkung vorgesehen ist,
Figur 4 ein Beispiel einer Vorrichtung mit einer linsenförmig vorgesehenen, die magnetische Flußdichte beeinflussenden Substanz,
Figur 5 ein zu Figur 4 alternatives Beispiel und
Figur 6 ein Beispiel einer Anordnung einer Vorrichtung in einem makroskopischen Magnetkreis.

### Beschreibung der Figuren

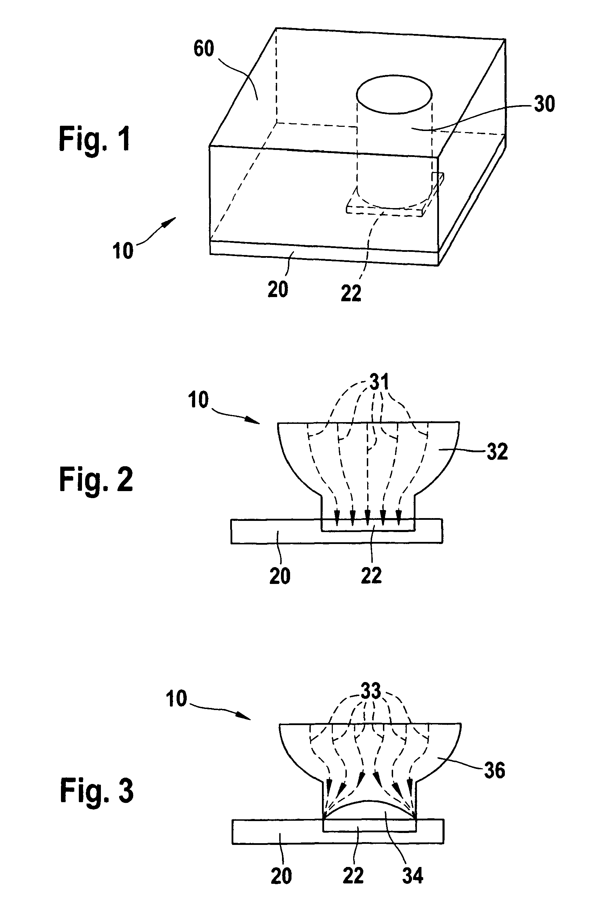

In Figur 1 ist eine Vorrichtung 10 zur Sensierung eines nicht dargestellten Magnetfeldes dargestellt. Die Vorrichtung 10 umfasst ein Substrat 20, welches insbesondere als Halbleitersubstrat, wie beispielsweise Siliziumsubstrat, vorgesehen ist. Auf oder in dem Substrat ist ein Magnetfeldsensor 22 vorgesehen, welcher insbesondere als Hallsensor, als bipolarer Magnetotransistor, als magnetoresistive Widerstandsschicht, als laterale MagFET-Struktur und dergleichen vorgesehen ist.

Weiterhin umfasst die Vorrichtung 10 eine die magnetische Flußdichte eines Magnetfeldes beeinflussende Substanz 30, welche im Bereich des Magnetfeldsensors 22 insbesondere auf einer Seite des Substrats 20 angeordnet ist. Weiterhin ist in Figur 1 eine Verpackungssubstanz 60 dargestellt, die die Vorrichtung 10 bzw. das Substrat 20 zumindest teilweise umhüllt.

In Figur 2 ist ein Beispiel der Vorrichtung 10 dargestellt, wobei der Einfachheit halber die Verpackungssubstanz 60 genauso wie in den Figuren 3, 4 und 5 nicht dargestellt ist. In Figur 2 ist wiederum das Substrat 20 und der Magnetfeldsensor 22 dargestellt. Vorrichtung 10 zeichnet sich hier dadurch aus, dass die die magnetische Flußdichte eines Magnetfeldes beeinflussende Substanz 30 mit dem Bezugszeichen 32 bezeichnet ist und im folgenden auch einfach als Substanz 30 bzw. Substanz 32 bezeichnet wird. Die Substanz 32 ist in Figur 2 beispielhaft trichterförmig vorgesehen, wobei oberhalb des Magnetfeldsensors 22 direkt oder indirekt die Substanz 32 vorgesehen ist, wobei die Substanz 32 von ihrem Querschnitt her zunimmt, je weiter man sich von der Substratebene, in welcher sich der Magnetfeldsensor 22 befindet, entfernt. Durch diese Querschnittsvergrößerung wird die trichterförmige Gestalt der Substanz 32 erreicht. Durch die trichterförmige Ausgestaltung der Substanz 32 kommt es zu einer Fokussierung von Flußlinien eines Magnetfeldes, welche in Figur 2 mit dem Bezugszeichen 31 versehen sind, auf die sensitive Chipfläche, d. h. auf den Magnetfeldsensor 22. Die Trichterform kann z. B. durch eine geeignete Gussform erzeugt werden. Durch die trichterförmige Ausgestaltung der Substanz 32 kommt es zu einer Fokussierung der Flußlinien 31 ausgehend von einer Ebene parallel zum Substrat 20 oberhalb des Magnetfeldsensors 32 hin zu einer Ebene auf dem Magnetfeldsensor 22.

In Figur 3 ist eine Ausführungsform der erfindungsgemäßen Vorrichtung 10 dargestellt, wobei die Substanz 30 nunmehr mit dem Bezugszeichen 36 bezeichnet ist und wobei eine weitere, die magnetische Flußdichte beeinflussende Substanz 34 vorgesehen ist, die im Wesentlichen linsenförmig zwischen dem Magnetfeldsensor 22 und der Substanz 36 vorgesehen ist. Hierbei ist es so, dass die Substanz 32 in Figur 2 genauso wie die Substanz 36 in Figur 3 flußkonzentrierende Wirkung aufweist und dass die weitere Substanz 34 magnetisch abschirmend vorgesehen ist. (Die abschirmende Wirkung wird z.B. dadurch erreicht, dass die Permeabilität der Substanz 34 deutlich geringer als die der Substanz 36 vorgesehen ist.) Bis auf die Tatsache, dass in Figur 3 oberhalb des Magnetfeldsensors 22 die weitere Substanz 34 linsenförmig, d. h. oberhalb des Magnetfeldsensors 22 etwa wie ein Wassertropfen geformt, vorgesehen ist, ist die Substanz 36 in Figur 3 ebenso trichterförmig, d. h. mit in Richtung vom Magnetfeldsensor 22 weg vergrößertem Querschnitt ausgebildet. In Figur 3 sind wiederum Magnetfeldlinien mit dem Bezugszeichen 33 versehen. Hierbei ist es so, dass in der zweiten Ausführungsform der erfindungsgemäßen Vorrichtung eine Fokussierung der magnetischen Flußdichte an den Rändern des Magnetfeldsensors 22 erzeugt wird, d. h. an den Stellen, wo die Linsenform der weiteren Substanz 34 eine geringere Dicke aufweist.

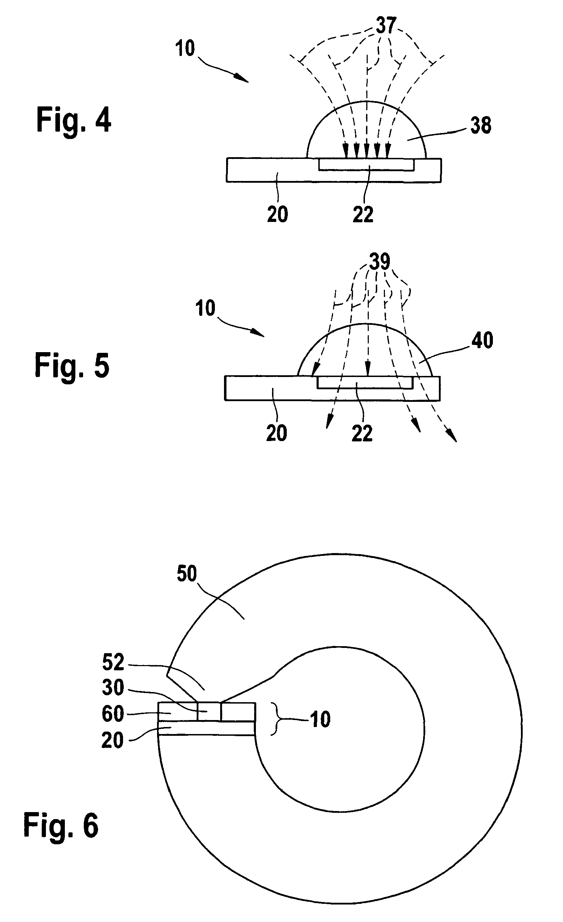

In Figur 4 ist ein weiteres Beispiel einer Vorrichtung 10 dargestellt, wobei wiederum der Magnetfeldsensor 22 auf bzw. in dem Substrat 20 vorgesehen ist, und wobei wiederum die magnetfeldkonzentrierend vorgesehene Substanz 30, in Figur 4 mit dem Bezugszeichen 38 versehen, dargestellt ist. In diesem Beispiel ist die Substanz 38 linsenförmig vorgesehen, was dazu führt, dass ein diffus einfallendes Magnetfeld, welches durch seine Magnetfeldlinien 37 dargestellt ist, im Zentrum der linsenförmig vorgesehenen Substanz 38 fokussiert wird.

In Figur 5 ist ein weiteres Beispiel einer Vorrichtung 10 wie in Figur 4 dargestellt, wobei jedoch in Figur 5 die Substanz 30 mit dem Bezugszeichen 40 versehen ist und wobei die mit dem Bezugszeichen 39 versehenen Magnetfeldlinien im Gegensatz zu Figur 4 nicht diffus einfallen sondern gerichtet einfallen. Dies führt durch die konvexe Form der Substanz 40 zu einer Defokussierung und damit einer Homongenisierung der Flußlinien auf der sensitiven Chipfläche, d. h. dem Magnetfeldsensor 22.

In Figur 6 ist ein Beispiel für die Reduktion des Luftspaltes in einem makroskopischen Magnetkreis dargestellt. Die Vorrichtung 10 ist in Figur 6 lediglich schematisch angedeutet, wobei das Substrat 20, die Substanz 30 und die Verpackungssubstanz 60 dargestellt sind. Weiterhin ist in Figur 6 ein makroskopischer Magnetkreis 50 vorgesehen, der ringförmig vorgesehen ist und einen Spalt umfasst, in welchem die Vorrichtung 10 eingebracht ist. Der makroskopische Magnetkreis 50 umfasst in Figur 6 beispielhaft einen Abschnitt 52, der in vorteilhafter Weise trichterförmig zu der Substanz 30 hin zuläuft. Der makroskopische Magnetkreis 50 ist insbesondere ebenfalls durch eine hochpermeable Vergussmasse erzeugt.

Die trichter- oder linsenförmige Form der Substanz 30, 32, 36, 38, 40 und der weiteren Substanz 34 erlaubt es, eine geeignete Flußlinienführung zu erreichen. Durch Verwendung einer hochpermeablen Vergussmasse als Substanz 30, 32, 36, 38, 40 können geeignete Formen je nach Applikationsbedarf auf das Substrat 20 bzw. den Chip 20 gegossen werden. Auch die Verwendung unterschiedlicher Vergussmassen, bzw. die Verwendung unterschiedlich permeabler Stoffe ist denkbar. Die Form der Linse bzw. des Trichters richtet sich danach, ob die zu messenden Flußlinien fokussiert oder defokussiert, d. h. homogenisiert, werden sollen und wie die Winkelverteilung der einfallenden Flußlinien verläuft. Beispielhaft ist es dadurch vorteilhaft möglich, parallele Flußlinien oder divergent einfallende Flußlinien am Ort des Magnetfeldsensors 22 zu erreichen. Es ist weiterhin möglich, außer der Substanz 30, 32, 36, 38, 40 die weitere Substanz 34 durch ein magnetisch abschirmendes Material zu realisieren und dadurch die Flußlinienführung zu beeinflussen. Hierdurch ist es beispielsweise möglich, Magnetfelder bewusst um abzuschirmende Bereiche herumzuführen. So können beispielsweise bestimmte Bereiche des Chips 20 bzw. des Substrats 20, wo sich z. B. ein elektromagnetisch empfindlicher Schaltkreis befindet, abgeschirmt werden.

Die Herstellung einer Substanz 30, 32, 36, 38, 40, die auch als On-Chip-Flußkonzentrator 30 bezeichnet wird, kann durch Vergießen eines einzelnen Chips 20 oder eines gesamten Wafers erfolgen, indem eine Maske oder eine mikroskopische bzw. makroskopische Vergussform geeignet angebracht wird.

Um beispielsweise eine hochpermeable Linse zu formen, kann ein vorrangehender Vergußschritt mit einer nieder- oder nichtpermeablen (µᵣ=1) Vergussmasse eine Vorform liefern, wie es insbesondere in Figur 3 dargestellt ist, auf welcher dann die eigentliche hochpermeable Vergussmasse, d. h. die Substanz 36, aufgebracht wird. Es kann jedoch auch zur Herstellung einer linsenförmigen Substanz 30 die Kapillarkraft ausgenutzt werden, um eine geeignete Wölbung der Vergussmasse zu erzeugen.

Durch die Verwendung unterschiedlicher Vergussmassen als Substanzen 30, 32, 36, 38, 40 bzw. weitere Substanz 34 mit unterschiedlicher Permeabilitätszahl - einstellbar beispielsweise über den Füllgrad eines hochpermeablen Füllstoffes in der Vergussmasse - oder durch Gradienten im Füllstoffgehalt einer Vergussmasse können entsprechende Gradienten der Permeabilitätszahl im On-Chip-Flußkonzentrator 30 erzeugt werden. Es besteht so die Möglichkeit, sogenannte Gradientenlinsen auf dem Chip 20 zu erzeugen, die in Analogie zu optischen Gradientenindexlinsen - d. h. mit ortsabhängigem Brechungsindex - magnetische Gradientenlinsen bilden, um eine besonders geeignete Flußlinienführung zu erzeugen.

Ferner ist unter Umständen je nach verwendetem hoch permeablem Füllstoff der Vergussmasse, beispielsweise Eisen, Kobalt, Nickel, eine geeignete Diffusionsbarriere zwischen dem Substrat 20, beispielsweise als Siliziumchip vorgesehen und der Vergussmasse vorzusehen. Eine solche geeignete Diffusionsbarriere ist erfindungsgemäß beispielhaft als Nitritpassivierungsschicht an der Chipoberfläche vorgesehen.

Durch die Höhe des auf dem Chip 20 aufgebrachten Flußkonzentrators 30 kann unter Umständen eine vorteilhafte Verbindung zu dem externen makroskopischen Flußkonzentrator 50 geschaffen werden, der beispielsweise als Magnetkreis um einen zu messenden Stromleiter herum ausgebildet ist. Dadurch erreicht man eine Bündelung des makroskopischen Magnetflusses und eine optimale Anbindung des Magnetfeldsensors 22 an den Magnetkreis, ohne einen allzu großen Luftspalt in dem makroskopischen Flußkonzentrator 50 zu erzeugen. Im Allgemeinen muss nämlich der Luftspalt eines makroskopischen Magnetkreises 50 relativ groß sein, wenn standardverpackte Sensoren in den Luftspalt eingebracht werden sollen, wodurch jedoch die Wirkung des im Luftspalt gebündelten Magnetflusses reduziert wird. Je geringer der Luftspalt in einem fast geschlossenen Magnetkreis ist, um so effektiver wirkt dieser Kreis. Die vorliegende Erfindung ermöglicht es in vorteilhafter Weise, den Luftspalt bis auf die Chipdicke quasi vollständig zu eliminieren, da im Wesentlichen nur noch die Dicke des Chips 20 als effektive Öffnung des Magnetkreises vorliegt.

Bei Bedarf kann auch die Vergussmasse selbst als Verpackung des Chips 20 dienen und auf diese Weise eine besonders gute Anbindung an den externen makroskopischen Magnetkreis 50 bilden. Weiterhin ist es denkbar, dass der On-Chip-Flußkonzentrator 30 geeignet aus der Chipverpackung 60 herausgeführt wird - beispielsweise durch eine hochpermeable Verbindungsstrecke, die z. B. entlang eines Lead-Frames geführt oder durch ein hochpermeables "Spezialbeinchen" des Lead-Frames dargestellt wird.

Die erfindungsgemäße Vorrichtung eignet sich insbesondere zum Gebrauch in einem Strommesser, wobei die Vorrichtung 10 das Magnetfeld in der Umgebung eines Stromleiters sensiert und so auf die in den Stromleiter fließende Stromstärke geschlossen wird.

## Patentansprüche

1. Vorrichtung (10) zur Sensierung eines Magnetfeldes mit einem Substrat (20), einem auf oder in dem Substrat (20) angeordneten Magnetfeldsensor (22), wobei die Vorrichtung (10) zumindest teilweise mittels einer Verpackungssubstanz (60) umhüllt vorgesehen ist und im Bereich des Magnetfeldsensors (22) eine die magnetische Flussdichte eines Magnetfeldes beeinflussende Substanz (30, 32, 36, 38, 40) vorgesehen ist, wobei die Form der Substanz derart vorgesehen ist, dass sich bei vorgegebenem Magnetfeld eine die magnetische Flussdichte fokussierende oder die magnetische Flussdichte defokussierende Wirkung am Magnetfeldsensor (22) ergibt, **dadurch gekennzeichnet, dass** die magnetische Flussdichte beeinflussende Substanz (30, 32, 36, 38, 40) eine geformte Vergussmasse ist und dass eine weitere, die magnetische Flussdichte beeinflussende Substanz (34) vorgesehen ist, wobei die weitere Substanz (34) im Wesentlichen linsenförmig zwischen dem Magnetfeldsensor (22) und der die magnetische Flussdichte beeinflussenden Substanz (30, 32, 36, 38, 40) vorgesehen ist und die weitere Substanz (34) magnetisch abschirmend vorgesehen ist

2. Vorrichtung (10) nach Anspruch 1, **dadurch gekennzeichnet, dass** der Magnetfeldsensor (22) auf oder in dem Substrat (20) monolithisch integriert vorgesehen ist.

3. Vorrichtung (10) nach Anspruch 1 oder Anspruch 2, **dadurch gekennzeichnet, dass** auf oder in dem Substrat (20) ein Auswerte- und/oder Ansteuerschaltkreis monolithisch integriert ist.

4. Vorrichtung (10) nach einem der vorhergehenden Ansprüche, **dadurch gekennzeichnet, dass** die die magnetische Flussdichte beeinflussende Substanz (30, 32, 36, 38, 40) einen trichterförmig oder linsenförmig ausgebildeten Körper umfasst.

5. Vorrichtung (10) nach einem der vorhergehenden Ansprüche, **dadurch gekennzeichnet, dass** die die magnetische Flussdichte beeinflussende Substanz (30, 32, 36, 38, 40) flusskonzentrierende Wirkung aufweist.

6. Vorrichtung (10) nach einem der vorhergehenden Ansprüche, **dadurch gekennzeichnet, dass** der Magnetfeldsensor (22) im Wesentlichen senkrecht zur Substratebene gerichtete Magnetfeldkomponenten sensiert.

7. Strommesser mit einer Vorrichtung (10) nach einem der vorhergehenden Ansprüche.

## Claims

1. Device (10) for sensing a magnetic field comprising a substrate (20), and a magnetic field sensor (22) arranged on or in the substrate (20), wherein the device (10) is provided in a manner enveloped at least partly by means of a packaging substance (60) and a substance (30, 32, 36, 38, 40) influencing the magnetic flux density of a magnetic field is provided in the region of the magnetic field sensor (22), wherein the form of the substance is provided in such a way that, for a predefined magnetic field, an effect which focuses the magnetic flux density or defocuses the magnetic flux density arises at the magnetic field sensor (22), **characterized in that** the substance (30, 32, 36, 38, 40) influencing the magnetic flux density is a shaped potting compound, and **in that** a further substance (34) influencing the magnetic flux density is provided, wherein the further substance (34) is provided in a substantially lens-shaped fashion between the magnetic field sensor (22) and the substance (30, 32, 36, 38, 40) influencing the magnetic flux density, and the further substance (34) is provided in a magnetically shielding fashion.

2. Device (10) according to Claim 1, **characterized in that** the magnetic field sensor (22) is provided in a manner monolithically integrated on or in the substrate (20).

3. Device (10) according to Claim 1 or Claim 2, **characterized in that** an evaluation and/or drive circuit is monolithically integrated on or in the substrate (20).

4. Device (10) according to any of the preceding claims, **characterized in that** the substance (30, 32, 36, 38, 40) influencing the magnetic flux density comprises a body formed in a funnel-shaped or lens-shaped fashion.

5. Device (10) according to any of the preceding claims, **characterized in that** the substance (30, 32, 36, 38, 40) influencing the magnetic flux density has a flux-concentrating effect.

6. Device (10) according to any of the preceding claims, **characterized in that** the magnetic field sensor (22) senses magnetic field components directed substantially perpendicularly to the substrate plane.

7. Ammeter comprising a device (10) according to any of the preceding claims.

## Revendications

1. Ensemble (10) de détection d'un champ magnétique, l'ensemble présentant
un substrat (20),
un détecteur (22) de champ magnétique disposé sur ou dans le substrat (20),
l'ensemble (10) étant au moins en partie enveloppé dans une substance d'emballage (60) et une substance (30, 32, 36, 38, 40) qui agit sur la densité de flux magnétique d'un champ magnétique étant prévue au niveau du détecteur (22) de champ magnétique,
la forme de la substance étant prévue de telle sorte que l'on obtienne sur le détecteur (22) de champ magnétique un effet de focalisation de la densité de flux magnétique ou un effet de défocalisation de la densité de flux magnétique pour un champ magnétique prédéterminé,
**caractérisé en ce que**
la substance (30, 32, 36, 38, 40) est une pâte de moulage façonnée,
**en ce qu'**une autre substance (34) qui agit sur la densité de flux magnétique est prévue,
**en ce que** l'autre substance (34) est prévue essentiellement en forme de lentille entre le détecteur (22) de champ magnétique et la substance (30, 32, 36, 38, 40) qui agit sur la densité de flux magnétique et
**en ce que** l'autre substance (34) exerce un effet de blindage magnétique.

2. Ensemble (10) selon la revendication 1, **caractérisé en ce que** le détecteur (22) de champ magnétique est intégré monolithiquement sur ou dans le substrat (20).

3. Ensemble (10) selon la revendication 1 ou la revendication 2, **caractérisé en ce qu'**un circuit d'évaluation et/ou de commande est intégré monolithiquement sur ou dans le substrat (20).

4. Ensemble (10) selon l'une des revendications précédentes, **caractérisé en ce que** la substance (30, 32, 36, 38, 40) qui agit sur la densité de flux magnétique comporte un corps en forme d'entonnoir ou en forme de lentille.

5. Ensemble (10) selon l'une des revendications précédentes, **caractérisé en ce que** la substance (30, 32, 36, 38, 40) qui agit sur la densité de flux magnétique présente un effet de concentration du flux.

6. Ensemble (10) selon l'une des revendications précédentes, **caractérisé en ce que** le détecteur (22) de champ magnétique détecte la composante du champ magnétique orienté essentiellement à la perpendiculaire du plan du substrat.

7. Ensemble de mesure de courant doté d'un ensemble (10) selon l'une des revendications précédentes.
